# EUROPEAN PATENT APPLICATION

(11) **EP 4 344 369 A1**
(43) Date of publication of application: **27.03.2024**
(21) Application number: 22819131.8
(22) Date of filing: 14.03.2022
(51) Int. Cl.: H05K 7/20, F25B 45/00

(54) **PUMP-DRIVEN TWO-PHASE LIQUID COOLING SYSTEM, AND LIQUID SUPPLEMENTATION CONTROL METHOD FOR PUMP-DRIVEN TWO-PHASE LIQUID COOLING SYSTEM**

(30) Priority: 09.06.2021 CN 202110642644
(71) Applicant: ZTE Corporation, Shenzhen, Guangdong 518057 (CN); Institute Of Spacecraft System Engineering, Beijing 100086 (CN)
(72) Inventor: TAO, Cheng, Shenzhen, Guangdong 518057 (CN); WANG, Yalong, Beijing 100086 (CN); LIU, Fan, Shenzhen, Guangdong 518057 (CN); LI, Shuai, Shenzhen, Guangdong 518057 (CN); ZHOU, Xiaodong, Beijing 100086 (CN); YU, Xingang, Beijing 100086 (CN)
(74) Representative: Zoli, Filippo
(86) International application number: PCT/CN2022/080758
(87) International publication number: WO 2022/257526

(57) **Abstract**

A pump-driven two-phase liquid cooling system, and a liquid supplementation control method for a pump-driven two-phase liquid cooling system. The pump-driven two-phase liquid cooling system comprises a pump-driven two-phase liquid circulation loop (100), a first liquid storage tank (200) and a second liquid storage tank (300), wherein a pump (110), an evaporator (120) and a condenser (130) are sequentially arranged in the pump-driven two-phase liquid circulation loop (100); the first liquid storage tank (200) is arranged at the front end of the pump (110); the second liquid storage tank (300) is in communication with the first liquid storage tank (200) by means of a first connecting pipeline (400), and is provided with a first liquid supplementation filling port (310); and the first connecting pipeline (400) is provided with a first valve (410) configured to separate the second liquid storage tank (300) from the first liquid storage tank (200).

## Description

### CROSS-REFERENCE TO RELATED APPLICATION

This application is filed on the basis of the Chinese patent application No. 202110642644.0 filed June 9, 2021, and claims priority of the Chinese patent application, the entire contents of which are incorporated herein by reference.

### TECHNICAL FIELD

The present disclosure relates to the technical field of thermal control, in particular to a pump-driven two-phase liquid cooling system and a method for controlling liquid refilling of a pump-driven two-phase liquid cooling system.

### BACKGROUND

With the development of communication technology, the power consumption of chips and communication equipment is getting higher and higher, and the traditional air cooling and single-phase liquid cooling will gradually fail to cover the heat dissipation demand. Pump-driven two-phase liquid cooling has great advantages in solving the heat dissipation demand with high power consumption. The operating principle of the pump-driven two-phase liquid cooling system lies in that the liquid working medium is driven by the pump into the evaporator to absorb the heat of chip with the phase of the liquid working medium changes, and the evaporated liquid working medium which is in gas-liquid form, enters the condenser for heat transfer, and turns into supercooled state, and then enters the pump again, and the cycle is repeated.

One of the core functions of the pump-driven two-phase liquid cooling system is to control the evaporation temperature and pressure of the system, which is completed by the liquid storage tank. Since the liquid storage tank is always in a gas-liquid mixed state, and the temperature and pressure correspond to each other, then the pressure and evaporation temperature of the whole system can be controlled by temperature control of the liquid storage tank. Another important function of the liquid storage tank is the volume change counteract. When the power consumption or operating temperature of the system changes, the total volume of the system working medium will change. The liquid storage tank counteracts this volume change through the change of liquid level to maintain the system pressure stability. Liquid working medium must be always present in the liquid storage tank, and the liquid level should be high enough, otherwise cavitation may occur at the pump inlet, which will affect the safe operation of the system. When the liquid level is not high enough due to insufficient filling of the system, changes in application scenarios and leakage of working medium, it is necessary to refill the liquid in time to ensure the stable and safe operation of the system.

Typically, the pump-driven two-phase liquid cooling system shall stop and cool to room temperature, and the working medium tank is connected into the system manually to refill the liquid, which is not suitable for the pump-driven two-phase liquid cooling system in communication equipment. If the system is not shut down, there is a risk that the system will be unstable during the fluid refilling. And the fluid refilling will be accompanied by a phase change. The fluid refilling point may become a second liquid storage tank, and at the same time, the temperature and pressure of the liquid storage tank will be changed, thus affecting the system pressure, and even the risk of liquid backflow may occur. Therefore, the current pump-driven two-phase liquid cooling system can not enable stable operation of the system when liquid refilling is carried out while the system is in operation.

### SUMMARY

Some embodiments of the present disclosure provide a pump-driven two-phase liquid cooling system and a method for controlling liquid refilling for the pump-driven two-phase liquid cooling system, which enable stable operation of the system when liquid refilling is carried out while the system is in operation.

An aspect of the present disclosure provides a pump-driven two-phase liquid cooling system. The system includes a pump-driven two-phase liquid circulation loop, where a pump, an evaporator, and a condenser are sequentially arranged in the pump-driven two-phase liquid circulation loop; a first liquid storage tank arranged at a front end of the pump; and a second liquid storage tank, which is in fluid communication with the first liquid storage tank through a first connecting pipeline; where the second liquid storage tank is provided with a first liquid filling port, and the first connecting pipeline is provided with a first valve arranged to isolate the second liquid storage tank from the first liquid storage tank.

According to another aspect of the present disclosure, an embodiment provides a method for controlling liquid refilling for a pump-driven two-phase liquid cooling system, where the pump-driven two-phase liquid cooling system includes a pump-driven two-phase liquid circulation loop, a first liquid storage tank, and a second liquid storage tank; the pump-driven two-phase liquid circulation loop is sequentially provided with a pump, an evaporator, and a condenser; the first liquid storage tank is arranged at a front end of the pump; the second liquid storage tank is in fluid communication with the first liquid storage tank through a first connecting pipeline; the second liquid storage tank is provided with a first liquid filling port, the first connecting pipe is provided with a first valve; the method includes, closing the first valve to isolate the second liquid storage tank from the first liquid storage tank; filling liquid into the second liquid storage tank through the first liquid filling port; and after the liquid refilling is completed, opening the first valve to communicate the second liquid storage tank with the first liquid storage tank, in response to a determination that a temperature difference between the second liquid storage tank and the first liquid storage tank is less than a preset threshold or a pressure difference between the second liquid storage tank and the first liquid storage tank is less than another preset threshold.

Some embodiments of the present disclosure include a pump-driven two-phase liquid cooling system and a method for controlling liquid refilling for the pump-driven two-phase liquid cooling system. According to the present disclosure, by the arranged first liquid storage tank and the second liquid storage tank, the second liquid storage tank is in fluid communication with the first liquid storage tank through the first connecting pipeline. When the system is in normal operation, both tanks act as a volume change counteractor. And when liquid filling is to be performed, the second liquid storage tank can be isolated from the first liquid storage tank by closing the first valve. Then the liquid is filled into the second liquid storage tank through the first liquid filling port. The second liquid storage tank is isolated from the system during liquid filling.

Other features and advantages of the present disclosure will be illustrated in the following description, and in part will be apparent from the description, or may be understood by practicing the present disclosure. The objects and other advantages of the present disclosure can be achieved and obtained by the structure particularly set forth in the description, claims and drawings.

### BRIEF DESCRIPTION OF DRAWINGS

The drawings are intended to provide a further understanding of the technical scheme of the present disclosure, and constitute a part of the specification, and they are intended to illustrate the technical scheme of the present disclosure in conjunction with the embodiments of the present disclosure, but are not intended to limit the technical scheme of the present disclosure.

Some embodiments of the present disclosure will be further illustrated with reference to the drawings.
FIG. 1 depicts a schematic diagram showing a pump-driven two-phase liquid cooling system according to Embodiment One of the present disclosure;
FIG. 2 depicts a schematic diagram showing a pump-driven two-phase liquid cooling system according to Embodiment Two of the present disclosure;
FIG. 3 depicts a schematic diagram showing a pump-driven two-phase liquid cooling system according to Embodiment Three of the present disclosure; and
FIG. 4 depicts a schematic diagram showing a temperature control part of a pump-driven two-phase liquid cooling system according to Embodiment Four of the present disclosure.

### DETAILED DESCRIPTION

This section will describe some embodiments of the present disclosure. Various embodiments of the present disclosure are shown in the drawings. The drawings are intended to illustrate to the description with graphics, so that the readers can intuitively and vividly understand each technical feature and the overall technical scheme of the present disclosure. The drawings, however, shall not be interpreted as limitations to the scope of the present disclosure.

It shall be understood that, in the description of an embodiment of the present disclosure, terms "first" and "second" if described, are intended for distinguishing technical features, which shall not be understood as indicating or implying relative importance or implicitly indicating the number of the indicated technical features or the order of the indicated technical features.

In the description of various embodiments of the present disclosure, the terms such as provide, mount or connect should be broadly understood, unless otherwise specified, and those having ordinary skills in the art can reasonably determine the specific meanings of the above terms in various embodiments of the present disclosure in conjunction with the specific contents of the technical scheme.

Some embodiments of the present disclosure provide a pump-driven two-phase liquid cooling system and a method for controlling liquid refilling for the pump-driven two-phase liquid cooling system, which enable stable operation of the system when liquid refilling is carried out while the system is in operation.

An aspect of the present disclosure provides a pump-driven two-phase liquid cooling system. The system includes a pump-driven two-phase liquid circulation loop, a first liquid storage tank, and a second liquid storage tank. A pump, an evaporator, and a condenser are sequentially arranged in the pump-driven two-phase liquid circulation loop. The first liquid storage tank is arranged at the front end of the pump. The second liquid storage tank is in fluid communication with the first liquid storage tank through a first connecting pipe. The second liquid storage tank is provided with a first liquid filling port. The first connecting pipe is provided with a first valve configured to isolate the second liquid storage tank from the first liquid storage tank.

By the arranged first liquid storage tank and the second liquid storage tank, the second liquid storage tank is in fluid communication with the first liquid storage tank through the first connecting pipeline. When the system is in normal operation, both tanks act as a volume change counteractor. And when liquid filling is to be performed, the second liquid storage tank can be isolated from the first liquid storage tank by closing the first valve. Then the liquid is filled into the second liquid storage tank through the first liquid filling port. The second liquid storage tank is isolated from the system during liquid filling, so that the system can operate stably when liquid refilling is carried out while the system is in operation.

Some embodiments of the present disclosure will be illustrated with reference to the drawings.

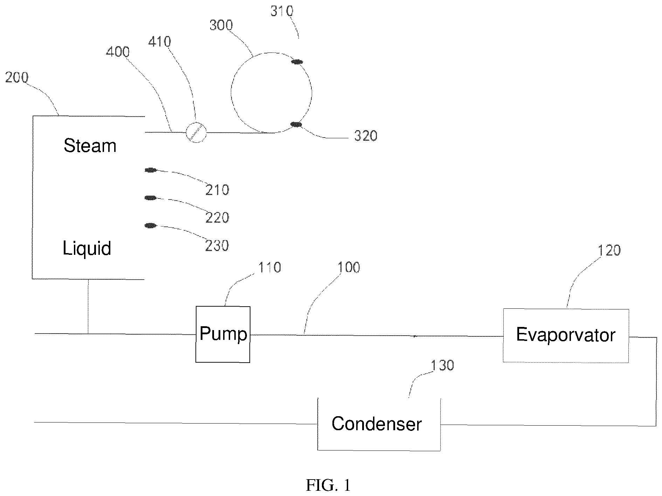

FIG. 1 depicts a pump-driven two-phase liquid cooling system according to Embodiment one of the present disclosure. The system includes a pump-driven two-phase liquid circulation loop 100, a first liquid storage tank 200 and a second liquid storage tank 300. A pump 110, an evaporator 120 and a condenser 130 are sequentially arranged in the pump-driven two-phase liquid circulation loop 100. The first liquid storage tank 200 is arranged at the front end of the pump 110. The first liquid storage tank 200 is provided with a maximum marked liquid level 210. The second liquid storage tank 300 is in fluid communication with the first liquid storage tank 200 through a first connecting pipe 400. The second liquid storage tank 300 is provided with a first liquid filling port 310. The first connecting pipe 400 is provided with a first valve 410 configured to isolate the second liquid storage tank 300 from the first liquid storage tank 200. The lowest part of the second liquid storage tank 300 is higher than the maximum marked liquid level 210 of the first liquid storage tank 200. In addition, the second liquid storage tank 300 is further provided with a suction port 320.

It can be understood that during the normal operation of the pump-driven two-phase liquid cooling system, both the first liquid storage tank 200 and the second liquid storage tank 300 act as a volume change counteractor. The first liquid storage tank 200 stores a mixture of gas and liquid, and the second liquid storage tank 300 stores gas merely. During the liquid filling, the second liquid storage tank 300 is isolated from the system for liquid filling, and then reconnected to the system after temperature and pressure adjustment. The liquid working medium is filled into the first liquid storage tank 200 by gravity without changing the system temperature and pressure. The first liquid storage tank 200 and the second liquid storage tank 300 continue to operate normally in the original state, thus solving the problem that the pump-driven two-phase liquid cooling system can not enable stable operation of the system when liquid refilling is carried out while the system is in operation, and greatly improving the maintainability and reliability of the system.

The first liquid storage tank 200 is arranged below the second liquid storage tank 300, in which the lowest part of the second liquid storage tank 300 is higher than the maximum marked liquid level 210 of the first liquid storage tank 200, so as to ensure that all the liquid in the second liquid storage tank 300 can flow into the first liquid storage tank 200 by gravity when the first valve 410 is opened. During normal operation, the first valve 410 is open, and the second liquid storage tank 300 is filled with gas. It can be understood that, the second liquid storage tank 300 stores as a part of the gas above the first liquid storage tank 200. The second liquid storage tank 300 and the first liquid storage tank 200 cooperate to realize the pressure and temperature adjustment.

It can be understood that temperature and pressure monitoring sensors are provided in both the first liquid storage tank 200 and the second liquid storage tank 300.

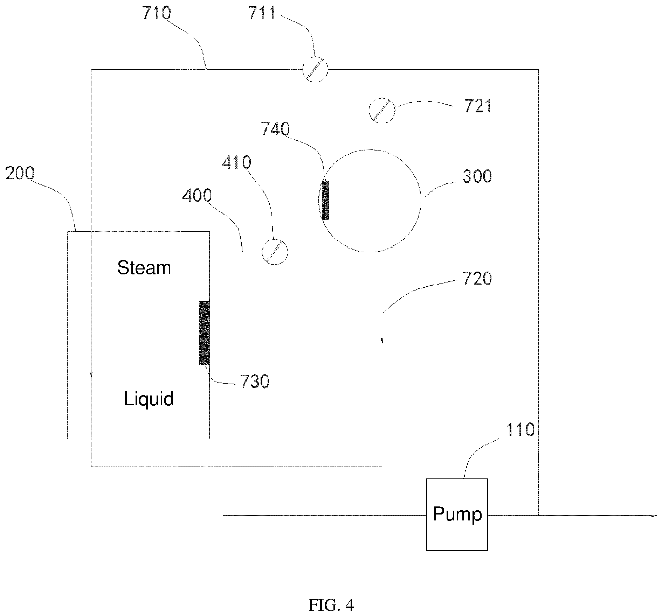

As shown in FIG. 4, the pump-driven two-phase liquid cooling system further includes a temperature control part. The temperature control part includes a first cooling branch 710 communicated from the rear end of the pump 110 to the front end of the pump 110, a second cooling branch 720 communicated from the rear end of the pump 110 to the front end of the pump 110, a first heater 730 arranged in the first liquid storage tank 200, and a second heater 740 arranged in the second liquid storage tank 300. The first cooling branch 710 is provided with a third valve 711. The second cooling branch 720 is provided with a fourth valve 721. A part of the pipeline of the first cooling branch 710 passes through the first liquid storage tank 200 to exchange heat with the working medium inside the first liquid storage tank 200. And a part of the pipeline of the second cooling branch 720 passes through the second liquid storage tank 300 to exchange heat with the working medium inside the second liquid storage tank 300.

The first cooling branch 710 and the first heater 730 can control the temperature of the first liquid storage tank 200. The second cooling branch 720 and the second heater 740 can control the temperature of the second liquid storage tank 300. The first heater 730 and the second heater 740 may be electric heating rods or thermoelectric sheets.

Typically, the temperature control of the second liquid storage tank 300 is enabled during the liquid filling merely, and is disabled when the pump-driven two-phase liquid cooling system is in normal operation. During the normal operation of the pump-driven two-phase liquid cooling system, the temperature control of the first liquid storage tank 200 is achieved through the first cooling branch 710 and the first heater 730.

It should be noted that the first liquid filling port 310 is designed as an interface with unlimited form, and which is configured to fill the second liquid storage tank 300 with liquid. The first liquid filling port can be directly connected with a working medium tank or other filling devices. The suction port 320 is designed as an interface with unlimited form, and which is configured to vacuumize the second liquid storage tank 300 before liquid filling, so as to improve the efficiency of liquid filling.

Return to FIG. 1 again, the first liquid storage tank 200 is provided with a middle marked liquid level 220 and a low marked liquid level 230 in addition to the maximum marked liquid level 210. When the pump-driven two-phase liquid cooling system is in the coldest working condition with no power consumption, the liquid level is between the middle marked liquid level 220 and the low marked liquid level 230. When the system in the hottest working condition with full power consumption, the liquid level is between the maximum marked liquid level 210 and the middle marked liquid level 220. When the system is running at full power consumption, and the liquid level drops below a certain level (for example, the middle marked liquid level 220 ) due to single board maintenance or leakage of working medium, the liquid level alarm is started for liquid refilling.

The low liquid level of the pump-driven two-phase liquid cooling system prompts fluid refilling. In such a case, the first valve 410 is closed to isolate the first valve 410 from the system. The second liquid storage tank 300 is vacuumized through the suction port 320 in order to reduce the pressure and expedite the fluid refilling. When the temperature and pressure of the second liquid storage tank 300 are significantly lower than the room temperature or the liquid working medium in the filling device, the vacuuming is unnecessary. The second liquid storage tank 300 is refilled with liquid through the first liquid filling port 310. During the refilling, the temperature and pressure of the second liquid storage tank 300 gradually increase. When the liquid level of the second liquid storage tank 300 reaches a required liquid level, the liquid refilling is stopped and the first liquid filling port 310 is disconnected. When the temperature and pressure of the first liquid storage tank 200 and the second liquid storage tank 300 are the same or close to each other, the first valve 410 is directly opened, and the liquid in the second liquid storage tank 300 spontaneously flows into the first liquid storage tank 200 through the first connecting pipe 400 without changing the system pressure and temperature. As such, the liquid level in the first liquid storage tank 200 rises to the level within a normal range, and the liquid refilling is completed. When the temperature and pressure of the second liquid storage tank 300 is lower than that of the first liquid storage tank 200, the temperature control of the second liquid storage tank 300 is enabled to heat or cool the temperature of the second liquid storage tank 300 to a level that is close to the temperature of the first liquid storage tank 200. And then the first valve 410 is opened. Under the condition that the pressure and temperature of the system do not change, the liquid in the second liquid storage tank 300 spontaneously flows into the first liquid storage tank 200 through the first connecting pipe 400. The liquid level in the first liquid storage tank 200 rises to a level within the normal range, and the liquid refilling is completed.

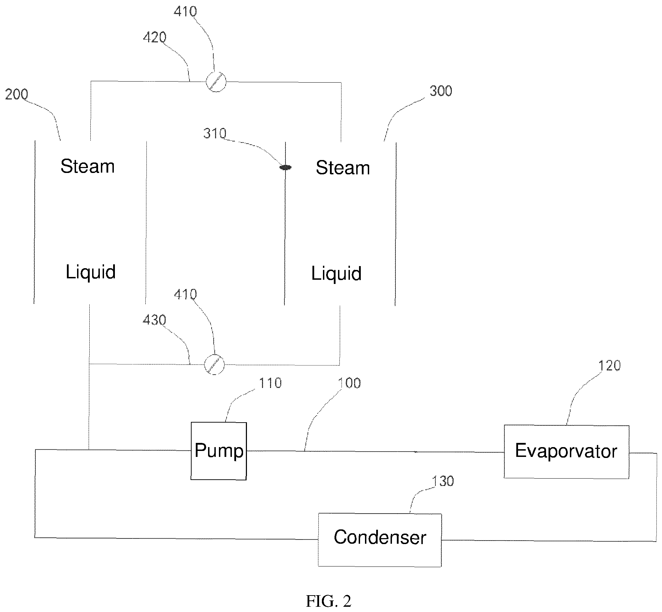

FIG. 2 depicts a pump-driven two-phase liquid cooling system according to Embodiment Two of the present disclosure. The system includes a pump-driven two-phase liquid circulation loop 100, a first liquid storage tank 200, and a second liquid storage tank 300. A pump 110, an evaporator 120, and a condenser 130 are sequentially arranged in the pump-driven two-phase liquid circulation loop 100. The first liquid storage tank 200 is arranged at the front end of the pump 110. The upper part of the first liquid storage tank 200 is in fluid communication with the upper part of the second liquid storage tank 300 through an upper connecting pipe 420. The lower part of the first liquid storage tank 200 is in fluid communication with the lower part of the second liquid storage tank 300 through a lower connecting pipe 430. Each of the upper connecting pipe 420 and the lower connecting pipe 430 is provided with a first valve 410. The second liquid storage tank 300 is provided with a first liquid filling port 310.

The Embodiment Two shown in FIG. 2 is similar to the Embodiment One shown in FIG. 1 in that:
During the liquid refilling, the second liquid storage tank 300 to be refilled is isolated from the system, and the second liquid storage tank 300 is to be re-connected to the system after the refilling is completed and the temperature of the second liquid storage tank 300 is controlled.

The total volume of the first liquid storage tank 200 and the second liquid storage tank 300 in Embodiment Two is the same as that of the first liquid storage tank 200 and the second liquid storage tank 300 in the Embodiment One.

The differences between the Embodiment Two shown in FIG. 2 and the Embodiment One shown in FIG. 1 are that the first liquid storage tank 200 is not necessarily arranged below the second liquid storage tank 300; And a mixture of liquid and gas is present in both the first and second liquid storage tanks during normal operation.

During normal operation, the first liquid storage tank 200 and the second liquid storage tank 300 can cooperatively perform temperature control to expedite the temperature control.

The second liquid storage tank 300 shall not be subjected to a vacuuming during the liquid refilling.

When the temperature and pressure of the second liquid storage tank 300 are higher than the room temperature or the working medium temperature of the filling device, the liquid refilling of this scheme is more complicated as compared to Embodiment One in that power shall be supplied to the refilling device or the temperature and pressure of the second liquid storage tank 300 shall be lowered down in advance.

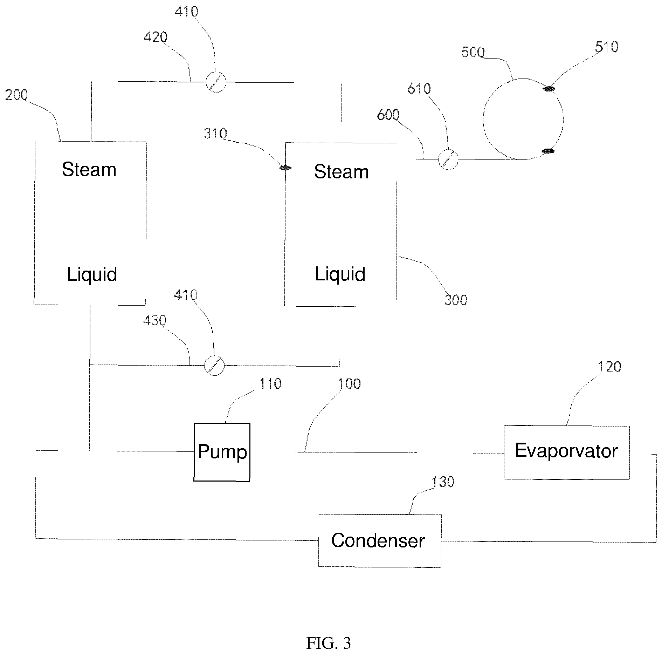

FIG. 3 depicts a pump-driven two-phase liquid cooling system according to Embodiment Three of the present disclosure. The system includes a pump-driven two-phase liquid circulation loop 100, a first liquid storage tank 200, a second liquid storage tank 300, and a third liquid storage tank 500. A pump 110, an evaporator 120, and a condenser 130 are sequentially arranged in the pump-driven two-phase liquid circulation loop 100. The first liquid storage tank 200 is arranged at the front end of the pump 110. The upper part of the first liquid storage tank 200 is in fluid communication with the upper part of the second liquid storage tank 300 through an upper connecting pipe 420. The lower part of the first liquid storage tank 200 is in fluid communication with the lower part of the second liquid storage tank 300 through a lower connecting pipe 430. Each of the upper connecting pipe 420 and the lower connecting pipe 430 is provided with a first valve 410. The second liquid storage tank 300 is provided with a first filling port 310. The third liquid storage tank 500 is connected to the second liquid storage tank 300 through a second connecting pipeline 600. The third liquid storage tank 500 is provided with a second liquid filling port 510. The second connecting pipeline 600 is provided thereon with a second valve 610 that is arranged to separate the third liquid storage tank 500 from the second liquid storage tank 300. The second liquid storage tank 300 is provided with a maximum marked liquid level. The lowest part of the third liquid storage tank 500 is higher than the maximum marked liquid level of the second liquid storage tank 300.

It can be understood that the scheme of the embodiment shown in FIG. 3 can be regarded as a combination of the embodiment shown in FIG. 1 and the embodiment shown in FIG. 2, and its functions and principles can be referred to Embodiment One and Embodiment Two, which are not repeated here.

According to another aspect, an embodiment of the present disclosure provides a method for controlling liquid refilling of a pump-driven two-phase liquid cooling system. Referring to FIG. 1, the pump-driven two-phase liquid cooling system includes a pump-driven two-phase liquid circulation loop 100, a first liquid storage tank 200, and a second liquid storage tank 300. The pump-driven two-phase liquid circulation loop 100 is sequentially provided with a pump 110, an evaporator 120, and a condenser 130. The first liquid storage tank 200 is arranged at the front end of the pump 110. The second liquid storage tank 300 is in fluid communication with the first liquid storage tank 200 through a first connecting pipeline 400. The second liquid storage tank 300 is provided with a first liquid filling port 310. The first connecting pipeline 400 is provided with a first valve 410. The method includes the following operations.

Closing the first valve 410 to isolate the second liquid storage tank 300 from the first liquid storage tank 200.

Filling the second liquid storage tank 300 with liquid through the first liquid filling port 310.

After the liquid refilling is completed, and when the temperature difference between the second liquid storage tank 300 and the first liquid storage tank 200 is less than a preset threshold or when the pressure difference between the second liquid storage tank 300 and the first liquid storage tank 200 is less than a preset threshold, the first valve 410 is opened to communicate the second liquid storage tank 300 with the first liquid storage tank 200.

The function and principle of this embodiment are the same as those of the pump-driven two-phase liquid cooling system of the Embodiment One described above, and will not be repeated here.

In the above-described method, the first liquid storage tank 200 is provided with the maximum marked liquid level 210, the lowest part of the second liquid storage tank 300 is higher than the maximum marked liquid level 210 of the first liquid storage tank 200. The second liquid storage tank 300 is further provided with a suction port 320. Before filling the second liquid storage tank 300 through the first liquid filling port 310, the method further includes the following operation.

Vacuumizing the second liquid storage tank 300 through the suction port 320.

In the above-described method, the upper part of the first liquid storage tank 200 is in fluid communication with the upper part of the second liquid storage tank 300 through the upper connecting pipe 420. The lower part of the first liquid storage tank 200 is in fluid communication with the lower part of the second liquid storage tank 300 through the lower connecting pipe 430. Each of the upper connecting pipe 420 and the lower connecting pipe 430 is provided with the first valve 410. In response to a determination that, at least one of a temperature difference, or a pressure difference between the second liquid storage tank 300 and the first liquid storage tank200 is greater than a preset threshold after liquid refilling, the temperature and pressure in the second liquid storage tank 300 are lowered.

In the above-described method, the pump-driven two-phase liquid cooling system further includes a temperature control part. Referring to FIG. 3, the temperature control part includes a first cooling branch 710 communicated from the rear end of the pump 110 to the front end of the pump 110, a second cooling branch 720 communicated from the rear end of the pump 110 to the front end of the pump 110, a first heater 730 arranged in the first liquid storage tank 200, and a second heater 740 arranged in the second liquid storage tank 300. The first cooling branch 710 is provided with a third valve 711. The second cooling branch 720 is provided with a fourth valve 721. A part of the pipeline of the first cooling branch 710 passes through the first liquid storage tank 200 to exchange heat with the working medium inside the first liquid storage tank 200. And a part of the pipeline of the second cooling branch 720 passes through the second liquid storage tank 300 to exchange heat with the working medium inside the second liquid storage tank 300. The method further includes the following operations.

Opening the fourth valve 721or enabling the first heater 730, in response to a determination that the temperature/pressure of the second liquid storage tank 300 is greater than the sum of the temperature/pressure of the first liquid storage tank 200 and a preset threshold.

And opening the third valve 711 or enabling the second heater 740, in response to a determination that the temperature/pressure of the second liquid storage tank 300 is less than the difference of the temperature/pressure of the first liquid storage tank 200 and a preset threshold.

Some embodiments of the present disclosure are described in conjunction with the drawings above. However, the present disclosure is not limited thereto. Various alternations can be made within the knowledge of those having ordinary skills in the art without departing from the scope of the present disclosure.

## Claims

1. A pump-driven two-phase liquid cooling system, comprising,
a pump-driven two-phase liquid circulation loop, wherein a pump, an evaporator, and a condenser are sequentially arranged in the pump-driven two-phase liquid circulation loop;
a first liquid storage tank, which is arranged at a front end of the pump; and
a second liquid storage tank, which is in fluid communication with the first liquid storage tank through a first connecting pipeline; wherein the second liquid storage tank is provided with a first liquid filling port, and the first connecting pipeline is provided with a first valve configured to isolate the second liquid storage tank from the first liquid storage tank.

2. The system as claimed in claim 1, wherein the first liquid storage tank is provided with a maximum marked liquid level, and a bottom of the second liquid storage tank is arranged at a level that is higher than the level of the maximum marked liquid level of the first liquid storage tank.

3. The system as claimed in claim 2, wherein the second liquid storage tank is further provided with a suction port.

4. The system as claimed in claim 1, wherein an upper part of the first liquid storage tank is in fluid communication with an upper part of the second liquid storage tank through an upper connecting pipeline, and a lower part of the first liquid storage tank is in fluid communication with a lower part of the second liquid storage tank through a lower connecting pipeline, and each of the upper connecting pipeline and the lower connecting pipeline is provided with the first valve.

5. The system as claimed in claim 4, further comprising a third liquid storage tank that is in fluid communication with the second liquid storage tank through a second connecting pipeline, wherein the third liquid storage tank is provided with a second liquid filling port; the second connecting pipeline is provided with a second valve which is configured to isolate the third liquid storage tank from the second liquid storage tank; the second liquid storage tank is provided with a maximum marked liquid level, and a bottom of the third liquid storage tank is arranged at a level that is higher than the level of the maximum marked liquid level of the second liquid storage tank.

6. The system as claimed in claim 1, further comprising a temperature control part, wherein the temperature control part comprises a first cooling branch communicated from a rear end of the pump to the front end of the pump, a second cooling branch communicated from the rear end of the pump to the front end of the pump, a first heater arranged in the first liquid storage tank, and a second heater arranged in the second liquid storage tank; wherein the first cooling branch is provided with a third valve; the second cooling branch is provided with a fourth valve, a part of the pipeline of the first cooling branch passes through the first liquid storage tank to exchange heat with a working medium in the first liquid storage tank, and a part of the pipeline of the second cooling branch passes through the second liquid storage tank to exchange heat with a working medium in the second liquid storage tank.

7. A method for controlling liquid refilling for a pump-driven two-phase liquid cooling system, wherein the pump-driven two-phase liquid cooling system comprises a pump-driven two-phase liquid circulation loop, a first liquid storage tank, and a second liquid storage tank; the pump-driven two-phase liquid circulation loop is sequentially provided with a pump, an evaporator, and a condenser; the first liquid storage tank is arranged at a front end of the pump; the second liquid storage tank is in fluid communication with the first liquid storage tank through a first connecting pipeline; the second liquid storage tank is provided with a first liquid filling port; the first connecting pipe is provided with a first valve; the method comprises,
closing the first valve to isolate the second liquid storage tank from the first liquid storage tank;
filling liquid into the second liquid storage tank through the first liquid filling port; and
after the liquid refilling is completed, opening the first valve to communicate the second liquid storage tank with the first liquid storage tank, in response to a determination that a temperature difference between the second liquid storage tank and the first liquid storage tank is less than a preset threshold or a pressure difference between the second liquid storage tank and the first liquid storage tank is less than another preset threshold.

8. The method as claimed in claim 7, wherein the first liquid storage tank is provided with a maximum marked liquid level, a bottom of the second liquid storage tank is arranged at a level that is higher than the level of the maximum marked liquid level of the first liquid storage tank, and the second liquid storage tank is further provided with a suction port; and before the liquid is filling into the second liquid storage tank through the first liquid filling port, the method further comprises,
vacuumizing the second liquid storage tank through the suction port.

9. The method as claimed in claim 7, wherein, an upper part of the first liquid storage tank is in fluid communication with an upper part of the second liquid storage tank through an upper connecting pipe, and a lower part of the first liquid storage tank is in fluid communication with a lower part of the second liquid storage tank through a lower connecting pipe, each of the upper connecting pipe and the lower connecting pipe is provided with the first valve, and after liquid refilling, lowering temperature and pressure in the second liquid storage tank, in response to a determination that, at least one of a temperature, or a pressure difference between the second liquid storage tank and the first liquid storage tank is greater than a preset threshold.

10. The system as claimed in claim 7, wherein the pump-driven two-phase liquid cooling system further comprises a temperature control part, wherein the temperature control part comprises a first cooling branch communicated from a rear end of the pump to the front end of the pump, a second cooling branch communicated from the rear end of the pump to the front end of the pump, a first heater arranged in the first liquid storage tank, and a second heater arranged in the second liquid storage tank; wherein the first cooling branch is provided with a third valve; the second cooling branch is provided with a fourth valve, a part of the pipeline of the first cooling branch passes through the first liquid storage tank to exchange heat with a working medium in the first liquid storage tank, and a part of the pipeline of the second cooling branch passes through the second liquid storage tank to exchange heat with a working medium in the second liquid storage tank; the method further comprises,
opening the fourth valve or enabling the first heater, in response to a determination that a temperature or pressure of the second liquid storage tank is greater than a sum of the temperature or pressure of the first liquid storage tank and the preset threshold; and
opening the third valve or enabling the second heater in response to a determination that a temperature or pressure of the second liquid storage tank is less than a difference of the temperature or pressure of the first liquid storage tank and the preset threshold.
